# FASCICULE DE BREVET EUROPEEN

(11) **EP 0 550 306 B1**
(45) Date de publication et mention de la délivrance du brevet: **14.05.1997**
(21) Numéro de dépôt: 92403412.7
(22) Date de dépôt: 15.12.1992
(51) Int. Cl.: G01R 33/09

(54) **Capteur de champ magnétique faible à effet magnétorésistif**
Magnetoresistiver Fühler für schwache Magnetfelder
Magneto-resistive sensor for weak magnetic fields

(30) Priorité: 23.12.1991 FR 9116042
(43) Date de publication de la demande: 07.07.1993
(73) Titulaire: THOMSON-CSF, 75008 Paris (FR)
(72) Inventeur: Schuhl, Alain, F-92402 Courbevoie Cedex (FR); TYC, Stéphane, F-92402 Courbevoie Cedex (FR)
(74) Mandataire: Guérin, Michel

(56) Documents cités:
- EP-A- 0 406 060
- EP-A- 0 485 129
- PHYSICAL REVIEW, B. CONDENSED MATTER vol. 43, no. 1B, 1 Janvier 1991, NEW YORK US pages 1297 - 1300 B.DIENY E.A. 'Giant magnetoresistance in soft ferromagnetic multilayers'
- JOURNAL OF APPLIED PHYSICS vol. 67, no. 9, 1 Mai 1990, NEW YORK US pages 5925 - 5930 M.B.STEARNS E.A. 'Antiferromagnetic coupling between layers in Co/Cr multilayer'
- PHYSICAL REVIEW, B. CONDENSED MATTER vol. 39, no. 7, 1 Mars 1989, NEW YORK US pages 4828 - 4830 G.BINASCH E.A, 'Enhanced magnetoresistance in layered magnetic structures with antiferromagnetic interlayer exchange'
- APPLIED PHYSICS LETTERS vol. 58, no. 20, 20 Mai 1991, NEW YORK US pages 2306 - 2308 M.A.BRUBAKER E.A. 'Oscillatory interlayer magnetic coupling of sputtered Fe/Mo superlattices'
- PHYSICAL REVIEW, B. CONDENSED MATTER vol. 44, no. 10, 1 Septembre 1991, NEW YORK US pages 5358 - 5361 V.S.SPEROSU E.A. 'Nonoscillatory magnetoresistance in Co/Cu/Co layered structures with oscillatory coupling'

## Description

La présente invention concerne un capteur de champ magnétique faible, à effet magnétorésistif, et plus précisement la structure des couches de matériaux qui le constituent.

On appelle capteur à effet magnétorésistif un capteur utilisant la variation de résistivité d'au moins un matériau le formant en fonction de la variation d'un champ magnétique. Un champ magnétique faible est le champ rayonné par la bande d'un enregistrement magnétique, par exemple.

Divers types de capteurs à effet magnétorésistif sont connus et sont mis en oeuvre dans des systèmes de lecture d'enregistrement magnétique : rubans, tambours, disquettes. Ces capteurs comportent une partie monolithique, un bloc, en un alliage ferromagnétique à forte magnéto-résistance, qui est placé dans le circuit magnétique d'une tête de lecture, laquelle reproduit les variations de la résistance électrique du capteur magnéto résistif au cours du défilement d'un enregistrement. Les alliages les plus utilisés, actuellement, sont des alliages ferromagnétiques à base de nickel, tels que NiCo, NiFe (Permalloy) à magnétorésistance élevée mais qui, à température ambiante, ne fournissent une variation relative de résistance que de quelques pour cent.

Des capteurs plus sensibles ont été mis au point plus récemment : ils utilisent un phénomène connu sous le nom de "magnétorésistance géante", développée lorsque l'élément sensible du capteur est constitué par une multicouche de métaux magnétiques et non-magnétiques alternées. Dans cette multicouche, les couches magnétiques sont couplées de type ferromagnétique (parallèle), hors champ magnétique, ou de type antiferromagnétique (anti-parallèle), sous champ magnétique, et la transition d'un état à l'autre se fait sur un faible intervalle de champ. L'inconvénient de ces capteurs multicouches est la trop haute valeur du champ magnétique nécessaire au "retournement" pour faire transiter les aimantations des couches de l'état parallèle à l'état anti-parallèle. Un champ magnétique élevé est nécessaire lorsque les couches sont d'épaisseurs régulières et couplées entre elles. L'énergie de "retournement" est égale à la somme des énergies de couplage d'une couche avec les deux couches adjacentes. On trouvera un exemple de réalisation d'un tel dispositif dans la demande de brevet européen n° 0 406 060 A1.

L'invention propose un capteur de champ magnétique faible à effet magnétorésistif et à structure multicouche, dans lequel l'énergie de retournement est faible et convient à la mesure d'un champ magnétique faible. Un capteur selon l'invention comporte au moins une cellule dans laquelle deux couches de matériaux non-magnétiques alternent régulièrement avec trois couches de matériaux magnétiques. Les épaisseurs des deux couches non-magnétiques sont différentes, et telle que la couche magnétique centrale est couplée de façon antiferromagnétique avec une première couche magnétique voisine et de façon ferromagnétique avec une deuxième couche magnétique voisine : quelle que soit l'orientation de l'aimantation de la couche centrale, un des deux couplages est frustré, c'est-à-dire qu'il ne correspond pas à ce qu'il devrait être en l'absence d'autres couplages et interactions magnétiques.

De façon plus précise, l'invention concerne un capteur de champ magnétique faible à effet magnétorésistif, comportant un multicouche métallique formé par au moins trois couches de matériaux magnétiques alternées avec deux couches de matériaux non-magnétiques, ce capteur étant caractérisé en ce que l'épaisseur de la première couche non-magnétique est choisie pour avoir un couplage antiferromagnétique entre la première et la deuxième couches magnétiques, et en ce que l'épaisseur de la deuxième couche non-magnétique est choisie pour avoir un couplage ferromagnétique entre la deuxième et la troisième couches magnétiques, les aimantations des première et troisième couches magnétiques étant bloquées dans une configuration ferromagnétique entraînant un phénomène de frustration des couplages, quel que soit le champ magnétique mesuré par ce capteur.

L'invention sera mieux comprise par la description qui suit d'un exemple d'application, en liaison avec les figures jointes en annexe, qui représentent :
- figures 1 et 2 : structure multicouche à magnétorésistance géante, montrant les types de couplage anti-ferromagnétique (fig 1) et ferromagnétique (fig. 2)
- figure 3 : courbe montrant la variation de la magnétorésistance en fonction du champ magnétique,
- figure 4 : courbe montrant la variation de la magnétorésistance en fonction de l'épaisseur de matériaux non-magnétiques.
- figures 5 et 6 : deux structures multicouches à effet magnétorésistif selon l'invention, en cellule élémentaire (fig. 5) et en réseau (fig. 6).

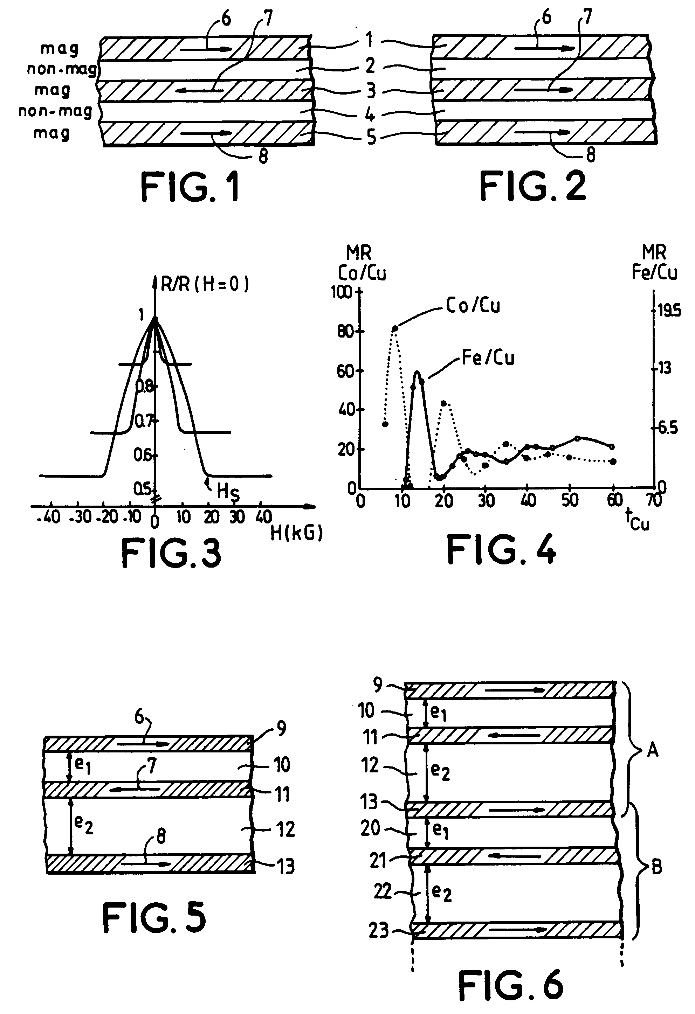

La figure 1 représente une fraction d'un multicouche à magnétorésistance géante : cette structure est en soi connue, mais elle constitue le fondement du capteur selon l'invention. Sur un substrat rigide -qui n'est pas représenté - est formée, par pulvérisation cathodique par exemple, une structure multicouche monocristalline obtenue par l'empilement de couches d'un matériau magnétique 1,3,5 , alternées avec des couches d'un matériau non-magnétique 2, 4.

Les matériaux non-magnétiques les plus utilisés sont Cu, Ag, Au, Mn, Cr, Va, Ti. Les matériaux magnétiques sont surtout Fe, Ni, Co, et les couples les plus courants sont Fe/Cr, Co/Au, Fe/Cu, bien que des couples de terres rares soient également cités : Gd/Y, Gd/Dy, Dy/Y, Y/Er... etc**.**

Les épaisseurs des couches 1 à 5 sont régulières - à la précision de dépôt près - et se situent dans une gamme de l'ordre de 5 à 100 angstrôms, telle que les couches de matériau magnétique 1, 3, 5 présentent, en l'absence de champ magnétique, un couplage de type antiferromagnétique. Ce type de couplage est illustré en figure 1 par les trois flêches symboliques 6, 7, 8 : en l'absence de champ magnétique extérieur si l'a imentation de la couche 1 magnétique est, par exemple, dirigée à droite sur la figure (flêche 6), l'aimentation de la couche 3 voisine - la couche 2 non-magnétique n'étant pas aimantée - est dirigée à gauche (flêche 7) donc antiparallèle et l'aimentation de la couche 5 magnétique est à nouveau dirigée à droite (flêche 8), donc à nouveau antiparallèle avec la précédente. Les états d'aimantation dans les couches magnétiques 1,3,5 sont, hors champ, dans un arrangement antiparallèle.

Sous l'action d'un champ magnétique parallèle aux couches magnétiques 1, 3, 5, l'état d'arrangement antiparallèle (couplage anti-ferromagnétique) de la figure 1 passe à l'état d'arrangement parallèle (couplage ferromagnétique) illustré en figure 2, dans lequel les états d'aimantation ont tous même orientation. La transition d'un état d'arrangement antiparallèle à un état d'arrangement parallèle se réalise dans un intervalle de champ magnétique faible.

La résistance électrique d'une structure multicouche varie selon l'état d'arrangement. Les électrons qui transportent le courant ont un spin qui peut avoir deux valeurs : + 1/2 ou -1/2, et qui correspond au sens de rotation d'un électron autour de son axe. Pour simplifier les explications, convenons de désigner ces deux types d'électrons comme électrons "hauts" et électrons "bas". Dans un multicouche en état antiparallèle (figure 1), les électrons "hauts" diffusent aux interfaces avec les couches qui ont un état d'aimantation "haute" (flêches 6,8) et les électrons "bas" diffusent aux interfaces avec les couches qui ont un état d'aimantation "basse" (flêche 7) : toutes les couches magnétiques 1, 3, 5 présentent la même résistance de valeur "élevée" au passage du courant, et la résistance du multicouche est élevée. Par contre, dans un multicouche en état parallèle (figure 2), les électrons "hauts" diffusent sur les couches "hautes", mais les électrons "bas" ne diffusent sur aucune couche (ou réciproquement). Par conséquent, les électrons "bas" amènent une faible résistance du multicouche. Il s'agit là de la magnétorésistance qui n'est dite géante que dans certaines spécificités de structure de multicouche et de nature des matériaux telles que la variation de résistance sous variation de champ magnétique, dans un domaine restreint, soit exploitable comme capteur à effet magnétorésistif.

La figure 3 montre la variation du rapport résistance sous champ/résistance hors champ R/R_{H = 0} en fonction du champ magnétique, pour trois structures de multicouches Fe/Cr, ayant différents épaisseurs de chrome. On voit que dans ce système la magnéto résistance R/R_{H = 0} peut varier dans le rapport 1 à 0,5 environ, mais que par contre cette variation, s'obtient au prix d'un champ magnétique de retournement Hₛ élevé, 20 kgauss (1G = 10⁻⁴T) sur cet exemple.

C'est là le principal inconvénient de ces capteurs : la trop haute valeur du champ magnétique de saturation Hₛ nécessaire pour obtenir le retournement parallèle/anti-parallèle relativise l'avantage que constitue la magnéto résistance géante. Pour diminuer Hₛ, on peut diminuer la force du couplage en augmentant la distance entre les couches, mais la magnétorésistance diminue très rapidement car on augmente le volume de métal conducteur de l'électricité sans augmenter le nombre d'interfaces où diffusent les électrons.

L'invention a pour objectif un capteur magnétorésistif fonctionnant avec un très faible champ magnétique qui utilise une propriété particulière de certaines multicouches métalliques, qui est la frustration des couplages magnétiques entre couches. Ceci permet de diminuer les champs de saturation Hₛ de ces capteurs.

On sait depuis très peu de temps que la magnétorésistance d'une structure multicouche métallique connaît un phénomène d'oscillation, en fonction de l'épaisseur des couches de matériau non-magnétique, tout au moins pour certains couples de matériaux. Plus précisement, la nature du couplage ferromagnétique ou anti-ferromagnétique- entre les couches magnétiques successives dépend de l'épaisseur de matériau non-magnétique qui les sépare (voir le document Applied Physic letters ; vol. 58, n° 20, 20 Mai 1991, pp 2306-2308).

La figure 4 illustre deux exemples de ce type d'oscillation de la magnétorésistance MR pour deux systèmes de matériaux Co/Cu et Fe/Cu, en fonction de l'épaisseur t_{Cu} des couches de cuivre, exprimée en angströms, les dites couches ayant une épaisseur régulière dans le multicouche. Les aimantations se placent dans une configuration anti-parallèle (couplage antiferromagnétique) aux très faibles épaisseurs de cuivre (inférieures à 10Å pour Co/Cu et à 15Å pour Fe/Cu), puis prennent une configuration parallèle (couplage ferromagnétique) lorsque l'épaisseur de cuivre augmente. En augmentant encore l'épaisseur de cuivre (supérieure à 15 Å et 20 Å respectivement), le système se retrouve dans une configuration anti-parallèle, et ainsi de suite.

Ce phénomène d'oscillation dans la nature du couplage magnétique entre couches est exploité dans le capteur de l'invention pour diminuer l'ancrage entre couches magnétiques sans diminuer la magnéto-résistance. La figure 5 représente une cellule élémentaire de ce capteur magnétorésistif.

La structure de cette cellule a en commun avec celle de la figure 1 d'être un multicouche métallique composé de trois couches magnétiques 9,11 et 13 alternées avec deux couches non-magnétiques 10 et 12. Le substrat qui supporte ce multicouche n'est pas représenté, non plus que sur la figure suivante. Les matériaux magnétiques (9, 11, 13) préférés sont le fer, le cobalt, le nickel, et les matériaux non-magnétiques (10, 12) préférés sont le cuivre, l'argent, l'or, le manganèse, le chrome, le vanadium ou le titane.

Une première caractéristique du capteur selon l'invention réside dans l'agencement des interactions qui couplent les diverses couches magnétiques : on crée une frustration de couplage pour diminuer les champs de saturation, et par conséquent les énergies de retournement. Pour ce faire, l'épaisseur e1 d'une première couche de matériau non-magnétique, par exemple la couche 10, est déterminée pour que la seconde couche magnétique, centrale, de la cellule, c'est à dire la couche 11, présente un couplage anti-ferromagnétique avec la première couche magnétique 9. Simultanément, l'épaisseur e2 de la deuxième couche de matériau non-magnétique, 12 dans ce cas, est déterminée pour que la même deuxième couche magnétique 11 présente un couplage ferromagnétique avec la troisième couche magnétique 13, ce couplage étant légèrement moins fort que le couplage anti-ferromagnétique précédent. Mais de plus, les matériaux des première et troisième couches magnétiques 9 et 13 sont choisis pour leur fort champ coercitif, de sorte que les aimantations (flêches 6 et 8) de ces deux couches sont bloquées dans une configuration ferromagnétique. Ainsi, les a imentations des couches 9 et 13 étant bloquées, et la nature des couplages entre les trois couches magnétiques étant commandée par les épaisseurs e₁ et e₂ des deux couches non-magnétiques, l'un des deux couplages est toujours frustré, quelle que soit l'orientation de l'aimantation**.**

Dans le cas exposé, la frustration concerne le couplage 11-13 parce qu'il a été choisi légèrement plus faible que le couplage 9-11, mais le choix des épaisseurs e₁ et e₂ et des matériaux peut aboutir à une situation inverse**.**

Une seconde caractéristique du capteur selon l'invention est relative au choix des matériaux magnétiques. Un système tel que Fe/Cu dans lequel un premier matériau magnétique est régulièrement alterné avec un second matériau non-magnétique appartient au domaine de l'invention s'il respecte les épaisseurs e₁ e₂ qui entraînent une frustration pour l'un des deux couplages entre couches magnétiques 9/11 et 13/11.

Cependant, selon l'invention, il est préférable de choisir deux matériaux magnétiques différents. Au niveau d'une cellule élémentaire telle qu'en figure 5 :
- les première et troisième couches magnétiques 9 et 13 sont en matériaux magnétiques "durs", c'est à dire à fort champ coercitif. Dans le fonctionnement normal du capteur, le champ magnétique à capter est trop faible pour retourner les aimantations de ces deux couches, qui sont bloquées en configuration ferromagnétique. C'est par exemple du cobalt.
- la deuxième couche magnétique 11, centrale à la cellule, est préférablement en matériau magnétique "doux" à faible champ de saturation, soit à faible énergie de retournement. C'est par exemple du fer.

La magnétorésistance géante apparaît quand l'aimantation de la couche centrale 11 permute de la position antiparallèle (antiferromagnétisme) vers la position parallèle (ferromagnétisme). Le champ nécessaire à cette permutation est déterminé par la différence d'énergie entre les deux positions, qui, du fait de la frustration d'un couplage, est égale à la différence entre les énergies E_{af} et E_{f} correspondant respectivement aux couplages antiferromagnétique et ferromagnétique : la conséquence en est une grand magnétorésistance à très faible champ magnétique, c'est à dire que le capteur selon l'invention est sensible à des champs faibles. Par opposition, dans les capteurs connus n'utilisant pas la frustration de couplage, l'énergie de retournement est égale à la somme des énergies E_{af} et E_{f}, et ces capteurs sont moins sensibles.

La figure 5 est dédiée à une cellule élémentaire. En fait, un capteur magnétorésistif comporte un grand nombre de semblables cellules : les exemples de 30,40 ou 60 couches sont fréquemment cités, et c'est la raison pour laquelle la figure 6 ne représente qu'une région d'un capteur selon l'invention, dont le substrat n'est pas représenté.

Dans ce cas plus général d'un grand nombre de couches, un capteur est constitué par un empilement de cellules repérées A, B... dans lesquelles la troisième couche magnétique (13, 23) d'une cellule constitue la première couche magnétique de la cellule suivante. L'ordre d'empilement des différentes couches de matériaux non-magnétiques peut être tel que des épaisseurs forment une suite de type e₁ e₂ e₁ e₂ e₁ ... etc ou une suite de type e₁ e₂ e₂ e₁ e₂.. mais il ne doit pas y avoir voisinage entre deux couches d'épaisseurs e₁, car la couche magnétique correspondante en matériau "doux" (11,21) ne serait pas frustrée : le capteur y perdrait en sensibilité. Les variantes dans l'ordre des épaisseurs e₁ et e₂ n'entrainent aucun changement dans l'ordre d'empilement des couches de matériaux magnétiques "durs" (9, 13, 23) et "doux" (11, 21).

De façon plus générale, un capteur magnétorésistif selon l'invention répond à une triple alternance:
- des couches de matériaux magnétiques sont alternées avec des couches de matériaux non-magnétiques,
- parmi les couches magnétiques, les matériaux de type "dur" à fort champ coercitif sont alternés avec les matériaux de type "doux" à faible champ de saturation,
- parmi les couches non-magnétiques, les épaisseurs varient de sorte que les couplages entre couches magnétiques sont alternativement de types ferromagnétique et antiferromagnétique.

Le capteur à magnétorésistance selon l'invention est utilisé notamment pour la lecture des enregistrements magnétiques.

## Revendications

1. Capteur de champ magnétique faible à effet magnétorésistif, comportant un multicouche métallique formé par au moins trois couches de matériaux magnétiques (9, 11, 13) alternées avec deux couches de matériaux non-magnétiques (10, 12), ce capteur étant caractérisé en ce que l'épaisseur (e₁) de la première couche non-magnétique (10) est choisie pour avoir un couplage antiferromagnétique entre la première (9) et la deuxième (11) couches magnétiques, et en ce que l'épaisseur (e₂) de la deuxième couche non-magnétique (12) est choisie pour avoir un couplage ferromagnétique entre la deuxième (11) et la troisième (13) couches magnétiques, les aimantations des première (9) et troisième (13) couches magnétiques étant bloquées dans une configuration ferromagnétique entraînant un phénomène de frustration des couplages, quel que soit le champ magnétique mesuré par ce capteur.

2. Capteur magnétorésistif selon la revendication 1, caractérisé en ce que, dans le multicouche métallique, les couches magnétiques (9, 11, 13) sont en matériaux qui sont alternativement de type "dur" à fort champ coercitif (9, 13) et de type "doux" à faible champ de saturation (11).

3. Capteur magnétorésistif selon la revendication 2, caractérisé en ce que l'aimantation des couches magnétiques de type "dur" (9, 13) est bloquée par leur fort champ coercitif.

4. Capteur magnétorésistif selon la revendication 2, caractérisé en ce que les couches magnétiques de type "doux" (11) sont celles dont le couplage magnétique est frustré, en raison des épaisseurs (e₁, e₂) des couches non-magnétiques (10, 12) adjacentes.

5. Capteur magnétorésistif selon la revendication 2, caractérisé en ce que les matériaux magnétiques "durs" sont choisis parmi Co, Ni ; le matérial magnétique "doux" est Fe, les matériaux non magnétiques sont choisis parmi Cu, Ag, Au, Mn, Cr, Va, Ti.

6. Capteur magnétorésistif selon l'une quelconque des revendications précédentes, caractérisé en ce qu'il possède une triple alternance :
- matériaux magnétiques (9, 11, 13, 21, 33) et non-magnétiques (10, 12, 20, 22) ;
- matériaux magnétiques de type "durs" (9, 13, 23) et "doux" (11, 21) ;
- matériaux non-magnétiques d'épaisseurs (e₁, e₂) choisies pour que les couplages des couches de matériaux "doux" (11, 21) soient l'un antiferromagnétique et l'autre ferromagnétique.

## Patentansprüche

1. Magnetoresistiver Fühler für schwache Magnetfelder mit einer metallischen Vielfachschicht aus wenigstens drei Schichten (9, 11, 13) aus magnetischen Materialien, die sich mit zwei Schichten (10, 12) aus nichtmagnetischen Materialien abwechseln, wobei der Fühler dadurch gekennzeichnet ist, daß die Dicke (e₁) der ersten nichtmagnetischen Schicht (10) so gewählt ist, daß sich zwischen der ersten (9) und der zweiten (11) magnetischen Schicht eine antiferromagnetische Kopplung ergibt, und daß die Dicke (e₂) der zweiten nichtmagnetischen Schicht (12) so gewählt ist, daß sich zwischen der zweiten (11) und der dritten (13) magnetischen Schicht eine ferromagnetische Kopplung ergibt, wobei die Magnetisierungen der ersten (9) und dritten (13) magnetischen Schicht in einer ferromagnetischen Konfiguration blockiert ist, was unabhängig von dem von dem Fühler gemessenen magnetischen Feld eine Frustrationserscheinung der Kopplungen erzeugt.

2. Magnetoresistiver Fühler nach Anspruch 1, dadurch gekennzeichnet, daß die Magnetschichten (9, 11, 13) in der metallischen Vielfachschicht aus Materialien bestehen, die abwechselnd vom Typ "hart" mit starkem Koerzitivfeld (9, 13) und vom Typ "weich" mit schwachem Sättigungsfeld (11) sind.

3. Magnetoresistiver Fühler nach Anspruch 2, dadurch gekennzeichnet, daß die Magnetisierung der magnetischen Schichten (9, 13) vom Typ "hart" durch ihr starkes Koerzitivfeld blockiert ist.

4. Magnetoresistiver Fühler nach Anspruch 2, dadurch gekennzeichnet, daß die magnetischen Schichten (11) vom Typ "weich" diejenigen sind, deren magnetische Kopplung wegen der Dicken (e₁, e₂) der benachbarten nichtmagnetischen Schichten (10, 12) frustriert ist.

5. Magnetoresistiver Fühler nach Anspruch 2, dadurch gekennzeichnet, daß die "harten" magnetischen Materialien aus Co, Ni ausgewählt sind, das "weiche" magnetische Material Fe ist und die nichtmagnetischen Materialien aus Cu, Ag, Au, Mn, Cr, Va, Ti ausgewählt sind.

6. Magnetoresistiver Fühler nach einem der vorhergehenden Ansprüche, dadurch gekennzeichnet, daß er einen Dreifachwechsel aufweist:
- magnetische Materialien (9, 11, 13, 21, 33) und nichtmagnetische Materialien (10, 12, 20, 22);
- magnetische Materialien vom Typ "hart" (9, 13, 23) und "weich" (11, 21);
- nichtmagnetische Materialien mit den Dicken (e₁, e₂), die so gewählt sind, daß die Kopplungen der Schichten der "weichen" Materialien (11, 21) bei einer antiferromagnetisch und bei der anderen ferromagnetisch sind.

## Claims

1. Magnetoresistive-effect sensor for weak magnetic fields, comprising a metallic multilayer formed by at least three layers of magnetic materials (9, 11, 13) alternating with two layers of non-magnetic materials (10, 12), this sensor being characterized in that the thickness (e₁) of the first non-magnetic layer (10) is chosen for there to be antiferromagnetic coupling between the first (9) and second (11) magnetic layers and in that the thickness (e₂) of the second non-magnetic layer (12) is chosen for there to be ferromagnetic coupling between the second (11) and third (13) magnetic layers, the magnetizations of the first (9) and third (13) magnetic layers being locked in a ferromagnetic configuration resulting in the phenomenon of coupling frustration, whatever the magnetic field measured by this sensor.

2. Magnetoresistive sensor according to Claim 1, characterized in that, in the metallic multilayer, the magnetic layers (9, 11, 13) are made of materials which are alternately of the "hard" type having a high coercive field (9, 11) and of the "soft" type having a low saturation field (11).

3. Magnetoresistive sensor according to Claim 2, characterized in that the magnetization of the "hard"-type magnetic layers (9, 11) is locked by their high coercive field.

4. Magnetoresistive sensor according to Claim 2, characterized in that the "soft"-type magnetic layers (11) are those for which the magnetic coupling is frustrated because of the thicknesses (e₁, e₂) of the adjacent non-magnetic layers (10, 12).

5. Magnetoresistive sensor according to Claim 2, characterized in that the "hard" magnetic materials are selected from Co, Ni; the "soft" magnetic material is Fe and the non-magnetic materials are selected from Cu, Ag, Au, Mn, Cr, Va and Ti.

6. Magnetoresistive sensor according to any one of the preceding claims, characterized in that it possesses a triple alternation:
- magnetic materials (9, 11, 13, 21, 33) and non-magnetic materials (10, 12, 20, 22);
- "hard"-type (9, 13, 23) and "soft"-type (11, 21) magnetic materials;
- non-magnetic materials having thicknesses (e₁, e₂) chosen so that the coupling of the layers of "soft" materials (11, 21) is in one case antiferromagnetic and in the other ferromagnetic.
